Europäisches Patentamt

European Patent Office

Office européen des brevets

(11) Publication number: **0 397 151 B1**

# EUROPEAN PATENT SPECIFICATION

(45) Date of publication of patent specification: **03.08.94**    (51) Int. Cl.⁵: **C01G 3/00**, C04B 35/00

(21) Application number: **90108753.6**

(22) Date of filing: **09.05.90**

(54) Oxide superconductor and process for preparing thereof.

(30) Priority: **12.05.89 JP 117261/89**

(43) Date of publication of application:
**14.11.90 Bulletin 90/46**

(45) Publication of the grant of the patent:
**03.08.94 Bulletin 94/31**

(84) Designated Contracting States:
**CH DE FR GB IT LI NL**

(56) References cited:
**EP-A- 0 380 347**

**JAPANESE JOURNAL OF APPLIED PHYSICS. PART 2 vol. 28, no. 1, January 1989, TOKYO JP pages 49 - 51; YOKOHAMA R: 'PREPARATION OF AN ALMOST SINGLE PHASE SUPERCONDUCTOR IN THE ND-CE-SR-CU-O SYSTEM'**

**PHYSICA C. SUPERCONDUCTIVITY vol. 161, no. 1, 15 October 1989, AMSTERDAM NL pages 6 - 8; T.SAKURAI: 'T*-T' PHASE CHANGE IN ND1.4SR0.4CE0.2CUO4-DELTA'**

(73) Proprietor: **MITSUBISHI MATERIALS CORPORATION**
**6-1, Otemachi 1-chome**
**Chiyoda-ku Tokyo(JP)**

Proprietor: **HITACHI, LTD.**
**6, Kanda Surugadai 4-chome**
**Chiyoda-ku, Tokyo 101(JP)**

Proprietor: **INTERNATIONAL SUPERCONDUCTIVITY TECHNOLOGY CENTER**
**No. 34-3, Shinbashi 5-chome**
**Minato-ku**
**Tokyo(JP)**

(72) Inventor: **Sakurai, Takeshi, c/o Superconductivity Res. Lab.**
**10-13, Shinonome 1-chome,**
**Koto-ku**
**Tokyo 135(JP)**
Inventor: **Yamashita, Toru, c/o Superconductivity Res. Lab.**
**10-13, Shinonome 1-chome,**
**Koto-ku**
**Tokyo 135(JP)**
Inventor: **Yamauchi, Hisao, c/o Superconductivity Res. Lab.**
**10-13, Shinonome 1-chome,**
**Koto-ku**
**Tokyo 135(JP)**

EP 0 397 151 B1

Inventor: **Tanaka, Shoji, c/o Superconductivity Res. Lab.**
**10-13, Shinonome 1-chome,**
**Koto-ku**
**Tokyo 135(JP)**


(74) Representative: **Bühling, Gerhard, Dipl.-Chem. et al**
**Patentanwaltsbüro**
**Tiedtke-Bühling-Kinne & Partner**
**Bavariaring 4**
**D-80336 München (DE)**

**Description**

The present invention relates to oxide superconductors and processes for preparing the same, and particularly to an oxide superconductor capable of exhibiting superconductivity within a wide range of composition and a process for preparing the same.

It is known that Nd-Ce-Cu-O oxides only falling within a very narrow range of composition can show superconductivity. For instance, Tokura et al. revealed that, among oxides represented by the composition formula: $Nd_{2-a}Ce_aCuO_{4-d}$, only those within the composition range of $0.14 \leq a \leq 0.18$ can exhibit superconductivity (Y. Tokura, H. Takagi and S. Uchida: Nature, Vol.337, pp. 345-347, 1989).

Superconductors of Nd-Ce-Cu-O system further including Sr added thereto are also under study. For instance, Akimitsu et al. reported that $Nd_{1.7}Sr_{0.4}Ce_{0.4}CuO_y$ ($Nd_2Sr_{0.5}Ce_{0.5}Cu_{1.2}Oy$) can exhibit superconductivity (J. Akimitsu et al.: Jpn. J. Appl. Phys., Vol. 27, No. 10, pp. L1859-1860, 1988), while Kosuge reported that oxides of Nd-Ce-Sr-Cu-O system can exhibit superconductivity within a very narrow range of composition, and that the superconducting transition temperature of $(Nd_{0.638}Ce_{0.087}Sr_{0.275})_2CuO_{4-d}$ is 22K (M. Kosuge: Jpn. J. Appl. Phys., Vol.28, No.1, pp.L49-51, 1989).

As described above, since oxides of Nd-Ce-Cu-O system as well as Nd-Ce-Sr-Cu-O system can exhibit superconductivity only within the very narrow range of composition, there have arisen many problems with the preparation thereof. More specifically, powders of starting materials must be very precisely weighed in the preparatory step, while mixing of the starting material powders must sometimes be effected according to a complicated method such as spray drying. Furthermore, homogenization of a composition must be effected through alternately repeated calcination and pulverization in order to prevent the superconductivity of a sinter after heat treatment from lowering due to poor homogeneity of the composition inside the sinter. Thus, many steps are required in the preparation of such an oxide superconductor.

EP-A-0 380 347, which represents a state of the art within the meaning of A 54(3) EPC, discloses a superconductor composition of a, besides others, Nd-Ce-Cu-O system, wherein Ce may be partially replaced by Ca, Sr and/or Ba. Specifically, a composition $Nd_{1.4}Ce_{0.2}Sr_{0.4}CnO_4$ showing a T* phase structure is disclosed. This superconducting composition is a hole type or p-type superconductor.

An object of the present invention is to obviate the above-mentioned defects of the prior art, and thereby to provide novel oxide superconductors which can develop a superconducting phase within a wide range of composition to facilitate the preparation thereof.

Another object of the present invention is to provide a simple process for preparing an oxide superconductor of the kind as described above.

In accordance with one aspect of the present invention, an N-type oxide superconductor of Nd-Ce-L-Cu-O system comprises a composition represented by the composition formula: $(Nd_xCe_yL_z)_2CuO_{4-d}$ (wherein L is an element selected from Ca and Mg, and x + y + z = 1), wherein the Nd-Ce-L composition thereof corresponds to a point falling inside an area of Nd-Ce-L ternary diagram surrounded by straight lines (A-B), (B-C), (C-D) and (D-A) connecting point (A) with point (B), point (B) with point (C), point (C) with point (D) and point (D) with point (A), respectively, the above-mentioned points (A), (B), (C) and (D) being points (x = 1, y = 0, z = 0), (x = 0.4, y = 0.6, z = 0), (x = 0.4, y = 0.3, z = 0.3) and (x = 0.1, y = 0, z = 0.9), respectively, in the Nd-Ce-L ternary diagram.

In accordance with another aspect of the present invention, an N-type oxide superconductor of Nd-Ce-Ae-Cu-O system comprises a composition represented by the composition formula: $(Nd_xCe_yAe_z)_2CuO_{4-d}$ (wherein Ae is a combination of at least two elements belonging to Group IIa of the periodic table, and x + y + z = 1), wherein the Nd-Ce-Ae composition thereof corresponds to a point falling inside an area of Nd-Ce-Ae ternary diagram surrounded by straight lines (A-B), (B-C), (C-D) and (D-A) connecting point (A) with point (B), point (B) with point (C), point (C) with point (D) and point (P) with point (A), respectively, the above-mentioned points (A), (B), (C) and (D) being points (x = 1, y = 0, z = 0), (x = 0.4, y = 0.6, z = 0), (x = 0.4, y = 0.3, z = 0.3) and (x = 0.1, y = 0, z = 0.9), respectively, in the Nd-Ce-M ternary diagram.

In a further aspect of the present invention, an oxide superconductor of Nd-Ce-L-Cu-O system comprises a composition represented by the composition formula: $(Nd_xCe_yL_z)_2CuO_{4-d}$ (wherein L is an element selected from Ca and Mg, and x + y + z = 1) and heat-treated in a reducing atmosphere after sintering, wherein the Nd-Ce-L composition thereof corresponds to a point falling inside an area of Nd-Ce-L ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points (x = 1, y = 0, z = 0), (x = 0.4, y = 0.6, z = 0), (x = 0.4, y = 0.3, Z = 0,3) and (x = 0.1, y = 0, z = 0.9), respectively, in said Nd-Ce-L ternary diagram.

In accordance with still a further aspect of the present invention, an oxide superconductor of Nd-Ce-Ae-Cu-O system comprises a composition represented by the composition formula: $(Nd_xCe_yAe_z)_2CuO_{4-d}$ (wherein Ae is a combination of at least two elements belonging to Group IIa of the periodic table, and $x + y + z = 1$) and heat-treated in a reducing atmosphere after sintering, wherein the Nd-Ce-Ae composition thereof corresponds to a point falling inside an area of Nd-Ce-Ae ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points ($x = 1$, $y = 0$, $z = 0$), ($x = 0.4$, $y = 0.6$, $z = 0$), ($x = 0.4$, $y = 0.3$, $Z = 0,3$) and ($x = 0.1$, $y = 0$, $z = 0.9$), respectively, in said Nd-Ce-Ae ternary diagram.

In accordance with still another aspect of the present invention, a process for preparing an oxide superconductor comprises the step of heat-treating in a reducing atmosphere of nitrogen an oxide sinter of the composition formula: $(Nd_xCe_yM_z)_2CuO_{4-d}$ (wherein M is an element selected from Sr, Ca and Mg, and $x + y + z = 1$), wherein the Nd-Ce-M composition thereof corresponds to a point falling inside an area of Nd-Ce-M ternary diagram surrounded by straight lines (A-B), (B-C), (C-D) and (D-A) connecting point (A) with point (B), point (B) with point (C), point (C) with point (D) and point (D) with point (A), respectively, the above-mentioned points (A), (B), (C) and (D) being points ($x = 1$, $y = 0$, $z = 0$), ($x = 0.4$, $y = 0.6$, $z = 0$), ($x = 0.4$, $y = 0.3$, $z = 0.3$) and ($x = 0.1$, $y = 0$, $z = 0.9$), respectively, in the Nd-Ce-M ternary diagram.

The step of heat-treating may be effected at a temperature within a range from 950°C to 1,100°C.

In accordance with a further aspect of the present invention, a process for preparing an oxide superconductor comprises the step of heat-treating in a reducing atmosphere of nitrogen an oxide sinter of the composition formula: $(Nd_xCe_yAe_z)_2CuO_{4-d}$ (wherein Ae is a combination of at least two elements belonging to Group IIa of the periodic table, and $x + y + z = 1$), wherein the Nd-Ce-Ae composition thereof corresponds to a point falling inside an area of Nd-Ce-Ae ternary diagram surrounded by straight lines (A-B), (B-C), (C-D) and (D-A) connecting point (A) with point (B), point (B) with point (C), point (C) with point (D) and point (D) with point (A), respectively, the above-mentioned points (A), (B), (C) and (D) being points ($x = 1$, $y = 0$, $z = 0$), ($x = 0.4$, $y = 0.6$, $z = 0$), ($x = 0.4$, $y = 0.3$, $z = 0.3$) and ($x = 0.1$, $y = 0$, $z = 0.9$), respectively, in the Nd-Ce-Ae ternary diagram.

The step of heat-treating may be effected at a temperature within a range from 950°C to 1, 100°C.

The above and other objects, effects, features and advantages of the present invention will become more apparent from the following description of embodiments thereof taken in conjunction with the accompanying drawings.

Fig. 1 is a ternary diagram illustrative of the composition range of Nd-Ce-Ca-Cu-O superconductors according to the present invention.

Figs. 2 and 3 are resistivity versus temperature characteristic diagram of respective oxide superconductors according to the present invention.

The oxide superconductors according to the present invention are oxides of Nd-Ce-Cu-O system having part of Ce substituted with Ca, Mg or at least two kinds of elements belonging to Group IIa of the periodic table. However, the processes according to the present invention can be applied to a wider range of composition encompassing oxides of Nd-Ce-Cu-O system having part of Ce substituted with one kind of element belonging to Group IIa except for Ba or with at least two kinds of elements belonging to Group IIa.

Substitution of part of Ce with an element or elements belonging to Group IIa in combination with a heat treatment in a reducing atmosphere after sintering can remarkably expand the range of composition wherein a superconducting phase appears. This eliminates the need for great consideration given to weighing and mixing of powders of starting materials, simplifies the total process for the preparation of an oxide superconductor, and decreases the lot-to-lot variation in the characteristics of the oxide superconductor due to the lot-to-lot variation in the composition thereof to enable a stable superconducting material to be supplied in an industrial aspect.

The following Examples will illustrate the present invention in detail.

A description will be made of oxides of Nd-Ce-Ca-Cu-O system and oxides of the above-mentioned system having part or the whole of Ca substituted with Sr as a representative case. $Nd_2O_3$, $CeO_2$, $CaCO_3$, $SrCO_3$, and CuO were used as starting materials in the form of a powder. These starting material powders were weighed in such a way as to correspond to various compositions. The weighed starting material powders were mixed in an agate mortar for about 5 minutes, and calcined in air at 950°C for 10 hours. The calcined powder was further pulverized and press-molded into a pellet, which was then sintered in air at 1,100°C for 15 hours. Subsequently, the pellet was heat-treated in a stream of nitrogen in a furnace at 1,050°C for 15 hours, and pulled out of the furnace to be quenched in a stream of nitrogen outside the furnace to room temperature. The resulting pellets with the respective various compositions were each examined by the four-probe method to find out respective variations in the electric resistance thereof with temperature.

4

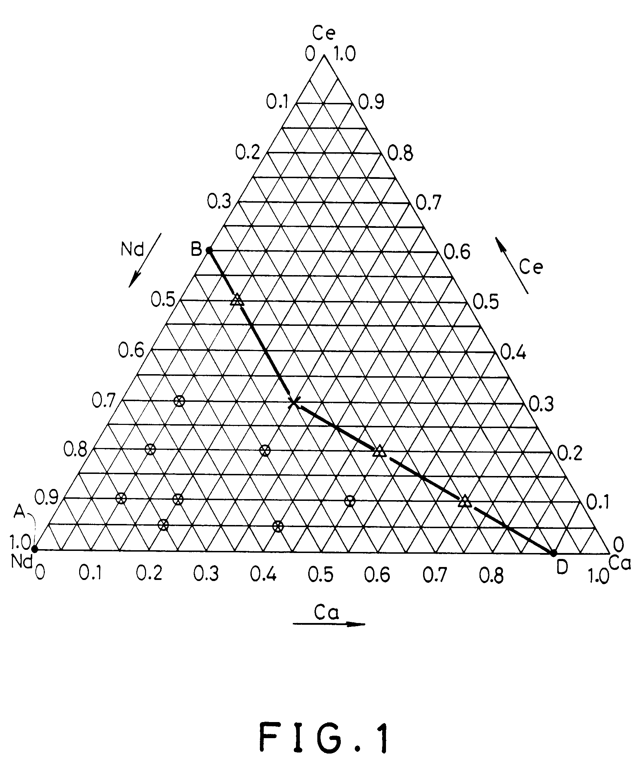

Table 1 shows the superconducting transition temperatures $T_{con}$ (onset temperatures) and compositions of the pellet samples of Examples, while Table 2 shows those of Comparative Examples. The pellet samples of Nd-Ce-Ca-Cu-O system of Examples 1 to 8 showed superconductivity, whereas the pellet samples of Comparative Examples 1 to 4 did not show superconductivity. Since the compositions of these samples can be represented by the composition formula: $(Nd_xCe_yCa_z)_2CuO_{4-d}$ (wherein $x + y + z = 1$), they can be plotted on a Nd-Ce-Ca ternary diagram. Fig. 1 shows an area corresponding to the range of superconducting compositions of Nd-Ce-Ca-Cu-O oxides. In the figure, the marks of $\bigcirc$ correspond to compositions which showed superconductivity, the marks of X to compositions which did not show superconductivity, and the marks of $\triangle$ to compositions, the electric resistances of which could not be measured because they were too high. As is apparent from Fig. 1, the range of compositions showing superconductivity corresponds to the inside of the area surrounded by straight lines (A-B), (B-C), (C-D) and (D-A) connecting point (A) with point (B), point (B) with point (C), point (C) with point (D) and point (D) with point (A), respectively, wherein points (A), (B), (C) and (D) are points ($x = 1$, $y = 0$, $z = 0$), ($x = 0.4$, $y = 0.6$, $z = 0$), ($x = 0.4$, $y = 0.3$, $z = 0.3$) and ($x = 0.1$, $y = 0$, $z = 0.9$), respectively. It can be understood that compositions just corresponding to points falling on the straight lines (B-C) and (C-D) do not show superconductivity. The compositions corresponding to points falling on the straight lines (A-B) and (D-A) are not included in the Nd-Ce-Ca ternary systems.

The pellet samples of Examples 9 to 11, which are in the form of an Nd-Ce-Ca-Cu-O oxide falling within the superconducting composition range and having part of Ca substituted with Sr, and the pellet samples of Examples 12 and 13, which are in the form of an Nd-Ce-Ca-Cu-O oxide falling in the superconducting composition range and having the whole of Ca substituted with Sr, showed superconductivity. The pellet samples of Comparative Examples 5 to 8, 9 to 11, and 13 had the same compositions as those of Examples 1 to 4, 9 to 11, and 13, respectively, but were prepared according to a customary procedure of sintering in oxygen at 1,120°C for 20 hours and slow cooling. These samples of Comparative Examples were an insulator or a conductor without superconductivity. Among the pellet samples of Comparative Examples subjected to a heat treatment in oxygen, there was only one pellet sample showing superconductivity, namely the sample of Comparative Example 12, which is known in the art.

Table 1

| Sample No. | | Composition | Atmosphere during Heat Treatment | $T_{con}$ (K) | Remarks |
|---|---|---|---|---|---|
| Example | 1 | $Nd_{1.6}Ce_{0.2}Ca_{0.2}CuO_{4-d}$ | | 9.0 | |
| | 2 | $Nd_{1.4}Ce_{0.2}Ca_{0.4}CuO_{4-d}$ | | 11.2 | |
| | 3 | $Nd_{1.5}Ce_{0.1}Ca_{0.4}CuO_{4-d}$ | | 15.0 | |
| | 4 | $Nd_{1.4}Ce_{0.4}Ca_{0.2}CuO_{4-d}$ | | 9.0 | |
| | 5 | $Nd_{0.8}Ce_{0.2}Ca_{1.0}CuO_{4-d}$ | | 8.0 | |
| | 6 | $Nd_{1.1}Ce_{0.1}Ca_{0.8}CuO_{4-d}$ | | 17.3 | |
| | 7 | $Nd_{1.0}Ce_{0.4}Ca_{0.6}CuO_{4-d}$ | $N_2$ | 11.0 | |
| | 8 | $Nd_{1.2}Ce_{0.6}Ca_{0.2}CuO_{4-d}$ | | 8.0 | |
| | 9 | $Nd_{1.4}Ce_{0.2}Ca_{0.2}Sr_{0.2}CuO_{4-d}$ | | 7.2 | |
| | 10 | $Nd_{1.32}Ce_{0.27}Ca_{0.11}Sr_{0.3}CuO_{4-d}$ | | 9.7 | |
| | 11 | $Nd_{1.32}Ce_{0.27}Ca_{0.21}Sr_{0.2}CuO_{4-d}$ | | 9.8 | |
| | 12 | $Nd_{1.4}Ce_{0.2}Sr_{0.4}CuO_{4-d}$ | | 11.1 | |
| | 13 | $Nd_{1.32}Ce_{0.27}Sr_{0.41}CuO_{4-d}$ | | 11.0 | |

Table 2

| Sample No. | | Composition | Atmosphere during Heat Treatment | Tcon (K) | Remarks |
|---|---|---|---|---|---|
| Comparative Example | 1 | Nd0.4Ce0.2Ca1.4CuO4-d | | – | Insulator |
| | 2 | Nd0.6Ce0.4Ca1.0CuO4-d | | – | Insulator |
| | 3 | Nd0.8Ce0.6Ca0.6CuO4-d | | – | |
| | 4 | Nd0.8Ce1.0Ca0.2CuO4-d | | – | Insulator |
| | 5 | Nd1.6Ce0.2Ca0.2CuO4-d | N2 | – | |
| | 6 | Nd1.4Ce0.2Ca0.4CuO4-d | | – | |
| | 7 | Nd1.5Ce0.1Ca0.4CuO4-d | | – | Insulator |
| | 8 | Nd1.4Ce0.4Ca0.2CuO4-d | | – | Insulator |
| | 9 | Nd1.4Ce0.2Ca0.2Sr0.2 CuO4-d | | – | |
| | 10 | Nd1.32Ce0.27Ca0.11Sr0.3CuO4-d | O2 | – | |
| | 11 | Nd1.32Ce0.27Ca0.21Sr0.2CuO4-d | | – | |
| | 12 | Nd1.4Ce0.2Sr0.4CuO4-d | | 21.8 | |
| | 13 | Nd1.32Ce0.27Sr0.41CuO4-d | | – | |

Next, a description will be made of oxides of Nd-Ce-Mg-Cu-O system and oxides of the above-mentioned system having part of Mg substituted with other element belonging to Group IIa. $Nd_2O_3$, $CeO_2$, $MgCO_3$, $BaCO_3$, $SrCO_3$ and $CuO$ were used as starting materials in the form of a powder. These starting material powders were weighed, mixed together, calcined, and press-molded in the same manner as in the foregoing case of the Nd-Ce-Ca-Cu-O oxides. The resulting pellets with respective various compositions

7

were sintered in air at 1,100°C for 15 hours, heat-treated in a stream of nitrogen in a furnace at 1,050°C for 15 hours, and then pulled out of the furnace to be quenched in a stream of nitrogen outside the furnace to room temperature. The resulting pellets with the respective various compositions were each examined by the four probe method to find out respective variations in the electric resistance thereof with temperature.

Table 3 shows the superconducting transition temperature $T_{con}$ (onset temperatures) and compositions of the pellet samples of Examples together with those of Comparative Examples. The compositions of these samples shown in Table 3 can be represented by the composition formula: $(Nd_xCe_yMg_z)_2CuO_{4-d}$ (wherein x + y + z = 1) or $(Nd_xCe_yAe_z)_2CuO_{4-d}$ (wherein Ae is a combination of at least two elements belonging to Group IIa, and x + y + z = 1). The pellet samples of Examples 14 to 22, which showed superconductivity, correspond to points falling inside the area surrounded by the straight lines (A-B), (B-C), (C-D) and (D-A) in the ternary diagram of Fig. 1 wherein Ca should be regarded as Mg or Ae in this case.

Table 3

| Sample No. | | Composition | Tcon (K) | Remarks |
|---|---|---|---|---|
| Example | 14 | $Nd_{1.8}Ce_{0.1}Mg_{0.1}CuO_{4-d}$ | 15.7 | |
| | 15 | $Nd_{1.2}Ce_{0.2}Mg_{0.6}CuO_{4-d}$ | 14.9 | |
| | 16 | $Nd_{0.8}Ce_{0.2}Mg_{1.0}CuO_{4-d}$ | 15.5 | |
| | 17 | $Nd_{1.2}Ce_{0.6}Mg_{0.2}CuO_{4-d}$ | 13.9 | |
| | 18 | $Nd_{1.8}Ce_{0.1}Mg_{0.05}Ba_{0.05}CuO_{4-d}$ | 7.4 | |
| | 19 | $Nd_{1.2}Ce_{0.2}Mg_{0.3}Ba_{0.3}CuO_{4-d}$ | 8.3 | |
| | 20 | $Nd_{1.8}Ce_{0.1}Mg_{0.05}Sr_{0.05}CuO_{4-d}$ | 11.7 | |
| | 21 | $Nd_{1.2}Ce_{0.2}Mg_{0.3}Sr_{0.3}CuO_{4-d}$ | 9.8 | |
| | 22 | $Nd_{1.2}Ce_{0.6}Mg_{0.1}Sr_{0.1}CuO_{4-d}$ | 12.9 | |
| Comparative Example | 14 | $Nd_{0.8}Ce_{1.0}Mg_{0.2}CuO_{4-d}$ | — | Insulator |
| | 15 | $Nd_{0.8}Ce_{0.2}Mg_{0.5}Sr_{0.5}CuO_{4-d}$ | — | Insulator |
| | 16 | $Nd_{0.8}Ce_{1.0}Mg_{0.1}Sr_{0.1}CuO_{4-d}$ | — | |

The fact that superconductors could be obtained within such a wide range of composition according to the present invention is attributable to substitution of part of Ce of $Nd_{2-a}Ce_aCuO_{4-d}$ with Ca, Mg or at least two elements belonging to Group IIa of the periodic table in combination with a heat treatment in a stream of nitrogen. Only sintering in an atmosphere containing oxygen according to the customary method does not provide superconductivity for most of $Nd_{2-a}Ce_aCuO_{4-d}$ oxides even having part of Ce substituted with Ca, Mg or at least two elements belonging to Group IIa. In contrast, a heat treatment in a stream of nitrogen after sintering remarkably expands the range of composition showing superconductivity. It was found out through X-ray diffractometry that the pellet samples which showed superconductivity had a crystal structure corresponding to N-type electric conduction. Accordingly, the reason for the foregoing expansion of the range of composition showing superconductivity is believed to be that a heat treatment in nitrogen allows nitrogen to act as such a reducing atmosphere as can strip an oxide of some oxygen atoms to increase the number of electrons as carriers. The amount of oxygen must be large in common P-type superconductors, which, therefore, needs the use of silver outer cylinders when formed into wires. In contrast, N-type superconductors can be used even when covered with a cheap metal incapable of feeding thereto oxygen later, such as copper and aluminum, because a small amount of oxygen therein will suffice. The heat treatment temperature is preferably in the range of 950°C to 1,100°C. Further, quenching in a stream of nitrogen can sharpen the drop of the electric resistance of the resulting oxide superconductor when cooled below the onset temperature thereof. The process can be simplified by effecting sintering in nitrogen after calcination.

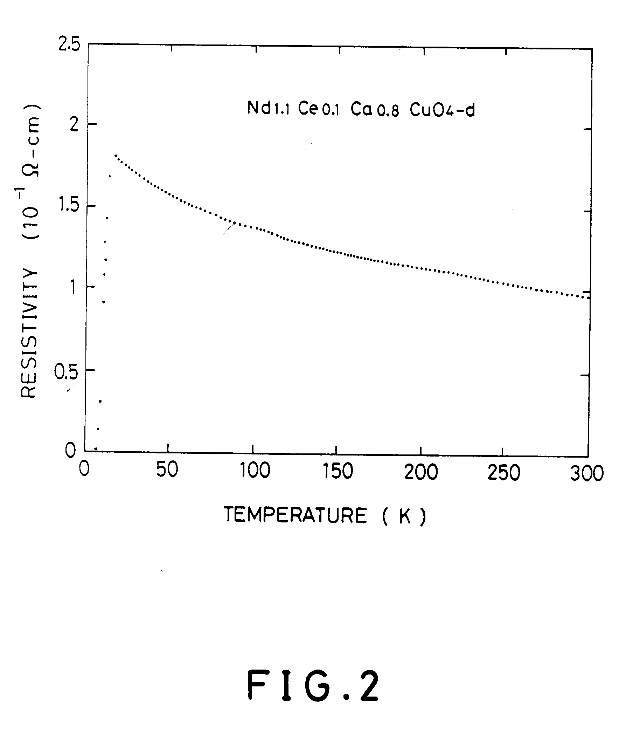

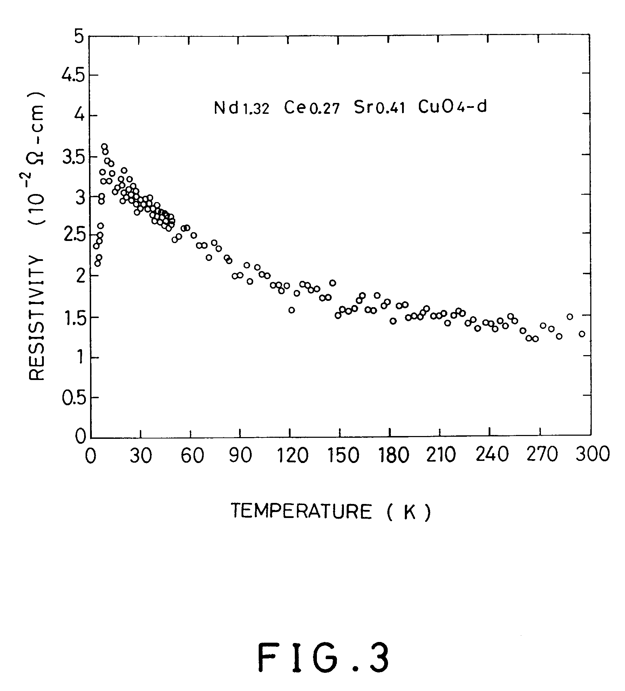

Figs. 2 and 3 show resistivity versus temperature characteristics of oxides with compositions: $Nd_{1.1}Ce_{0.1}Ca_{0.8}CuO_{4-d}$ and $Nd_{1.32}Ce_{0.27}Sr_{0.41}CuO_{4-d}$, respectively, by way of example. Both of the oxides had an onset temperature higher than 10K, and showed a sharp drop of electric resistance below the transition temperature.

As described hereinbefore, according to the present invention, substitution of part of Ce of an Nd-Ce-Cu-O oxide with an element or elements belonging to Group IIa of the periodic table in combination with a heat treatment in a reducing atmosphere after sintering can remarkably expand the range of composition showing superconductivity. This can simplify the method of weighing and mixing powders of starting materials, and eliminate the need of alternately repeated sintering and pulverization to prevent the unhomogeneity of the resulting composition. Accordingly, the process can be simplified with a shortened preparation time to lower the cost of preparation of an oxide superconductor.

The invention has been described in detail with respect to preferred embodiments, and it will now be apparent from the foregoing to those skilled in the art that changes and modifications may be made without departing from the invention and it is the invention, therefore, in the appended claims to cover all such changes and modifications as fall within the invention.

**Claims**

1. An N-type oxide superconductor of Nd-Ce-L-Cu-O system characterized by comprising:

   a composition represented by the composition formula: $(Nd_xCe_yL_z)_2CUO_{4-d}$ (wherein L is an element selected from Ca and Mg, and x + y + z = 1), wherein the Nd-Ce-L composition thereof corresponds to a point falling inside an area of Nd-Ce-L ternary diagram surrounded by straight lines (A-B), (B-C), (C-D) and (D-A) connnecting point (A) with point (B), point (B) with point (C), point (C) with point (D) and point (D) with point (A), respectively, said points (A), (B), (C) and ((D) being points (x = 1, y = 0, z = 0), (x = 0.4, y = 0.6, z = 0), (x = 0.4, y = 0.3, z= 0.3) and (x = 0.1, y = 0, z = 0.9), respectively, in said Nd-Ce-L ternary diagram.

2. An N-type oxide superconductor of Nd-Ce-Ae-Cu-O system characterized by comprising:

   a composition represented by the composition formula: $(Nd_xCe_yAe_z)_2CUO_{4-d}$ (wherein Ae is a combination of at least two elements belonging to Group IIa of the periodic table, and x + y + z = 1), wherein the Nd-Ce-Ae composition thereof corresponds to a point falling inside an area of Nd-Ce-Ae ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points (x = 1, y = 0, z = 0), (x = 0.4, y = 0.6, z = 0), (x = 0.4, y = 0.3, z = 0,3) and (x = 0.1, y = 0, z = 0.9), respectively, in said Nd-Ce-Ae ternary diagram.

3. An oxide superconductor of Nd-Ce-L-Cu-O system characterized by comprising:

   a composition represented by the composition formula: $(Nd_xCe_yL_z)_2CuO_{4-d}$ (wherein L is an element selected from Ca and Mg, and x + y + z = 1) and heat-treated in a reducing atmosphere after sintering, wherein the Nd-Ce-L composition thereof corresponds to a point falling inside an area of Nd-Ce-L ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points (x = 1, y = 0, z = 0), (x = 0.4, y = 0.6, z = 0), (x = 0.4, y = 0.3, z = 0,3) and (x = 0.1, y = 0, z = 0.9), respectively, in said Nd-Ce-L ternary diagram.

4. An oxide superconductor of Nd-Ce-Ae-Cu-O system characterized by comprising:

   a composition represented by the composition formula: $(Nd_xCe_yAe_z)_2CuO_{4-d}$ (wherein Ae is a combination of at least two elements belonging to Group IIa of the periodic table, and x + y + z = 1)

and heat-treated in a reducing atmosphere after sintering, wherein the Nd-Ce-Ae composition thereof corresponds to a point falling inside an area of Nd-Ce-Ae ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points ($x = 1$, $y = 0$, $z = 0$), ($x = 0.4$, $y = 0.6$, $z = 0$), ($x = 0.4$, $y = 0.3$, $Z = 0,3$) and ($x = 0.1$, $y = 0$, $z = 0.9$), respectively, in said Nd-Ce-Ae ternary diagram.

5. A process for preparing an oxide superconductor characterized by comprising the step of:
heat-treating in a reducing atmosphere of nitrogen an oxide sinter of the composition formula: $(Nd_xCe_yM_z)_2CuO_{4-d}$ (wherein M is an element selected from Sr, Ca and Mg, and $x + y + z = 1$), wherein the Nd-Ce-M composition thereof correponds to a point falling inside an area of Nd-Ce-M ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points ($x = 1$, $y = 0$, $z = 0$), ($x = 0.4$, $y = 0.6$, $z = 0$), ($x = 0.4$, $y = 0.3$, $z = 0,3$) and ($x = 0.1$, $y = 0$, $z = 0.9$), respectively, in said Nd-Ce-M ternary diagram.

6. A process for preparing an oxide superconductor as claimed in claim 5, characterized in that said step of heat-treating is effected at a temperature within a range from 950° to 1,100°C.

7. A process for preparing an oxide superconductor, characterized by comprising the step of:
heat-treating in a reducing atmosphere of nitrogen an oxide sinter of the composition formula: $(Nd_xCe_yAe_z)_2CuO_{4-d}$ (wherein Ae is a combination of at least two elements belonging to Group IIa of the periodic table, and $x + y + z = 1$), wherein the Nd-Ce-Ae composition thereof corresponds to a point falling inside an area of Nd-Ce-Ae ternary diagram surrounded by straight lines (A-B), (B-C), (C-D) and (D-A) connecting point (A) with point (B), point (B) with point (C), point (C) with point (D) and point (D) with point (A), respectively, said points (A), (B), (C) and (D) being points ($x = 1$, $y = 0$, $z = 0$), ($x = 0.4$, $y = 0.6$, $z = 0$), ($x = 0.4$, $y = 0.3$, $z = 0,3$) and ($x = 0.1$, $y = 0$, $z = 0.9$), respectively, in said Nd-Ce-Ae ternary diagram.

8. A process for preparing an oxide superconductor as claimed in claim 7, characterized in that said step of heat-treating is effected at a temperature within a range from 950°C to 1,100°C.

**Patentansprüche**

1. N-Typ Oxid-Supraleiter vom Nd-Ce-L-Cu-O-System, dadurch gekennzeichnet, daß er umfaßt:
eine Zusammensetzung, dargestellt durch die Summenformel: $(Nd_xCe_yL_z)_2CuO_{4-d}$ (worin L ein Element, ausgewählt aus Ca und Mg, ist und $x + y + z = 1$), wobei die Nd-Ce-L-Zusammensetzung der Zusammensetzung einem Punkt entspricht, der in eine Fläche des ternären Nd-Ce-L-Diagramms fällt, die von geraden Linien (A-B), (B-C), (C-D) und (D-A), die Punkt (A) mit Punkt (B), Punkt (B) mit Punkt (C), Punkt (C) mit Punkt (D) und Punkt (D) mit Punkt (A) jeweils verbinden, umgeben ist, wobei die Punkte (A), (B), (C) bzw. (D) Punkte ($x = 1$, $y = 0$, $z = 0$), ($x = 0,4$, $y = 0,6$, $z = 0$), ($x = 0,4$, $y = 0,3$, $z = 0,3$) bzw. ($x = 0,1$, $y = 0$, $z = 0,9$) in dem ternären Nd-Ce-L-Diagramm sind.

2. N-Typ Oxid-Supraleiter vom Nd-Ce-Ae-Cu-O-system, dadurch gekennzeichnet, daß er umfaßt:
eine Zusammensetzung, dargestellt durch die Summenformel: $(Nd_xCe_yAe_z)_2CuO_{4-d}$ (worin Ae eine Kombination von mindestens zwei Elementen, die zur Gruppe IIa des Periodensystems gehören, ist und $x + y + z = 1$), wobei die Nd-Ce-Ae-Zusammensetzung der Zusammensetzung einem Punkt entspricht, der in eine Fläche des ternären Nd-Ce-Ae-Diagramms fällt, die von geraden Linien (A-B), (B-C), (C-D) und (D-A), die Punkt (A) mit Punkt (B), Punkt (B) mit Punkt (C), Punkt (C) mit Punkt (D) und Punkt (D) mit Punkt (A) jeweils verbinden, umgeben ist, wobei die Punkte (A), (B), (C) bzw. (D) Punkte ($x = 1$, $y = 0$, $z = 0$), ($x = 0,4$, $y = 0,6$, $z = 0$), ($x = 0,4$, $y = 0,3$, $z = 0,3$) bzw. ($x = 0,1$, $y = 0$, $z = 0,9$) in dem ternären Nd-Ce-Ae-Diagramm sind.

3. Oxid-Supraleiter vom Nd-Ce-L-Cu-O-System, dadurch gekennzeichnet, daß er umfaßt:
eine Zusammensetzung, dargestellt durch die Summenformel: $(Nd_xCe_yL_z)_2CuO_{4-d}$ (worin L ein Element, ausgewählt aus Ca und Mg, ist und $x + y + z = 1$) und in einer reduzierenden Atmosphäre nach dem Sintern wärmebehandelt, wobei die Nd-Ce-L-Zu-sammensetzung der Zusammensetzung einem Punkt entspricht, der in eine Fläche des ternären Nd-Ce-L-Diagramms fällt, die von geraden Linien (A-B), (B-C), (C-D) und (D-A), die Punkt (A) mit Punkt (B), Punkt (B) mit Punkt (C), Punkt (C) mit Punkt (D) und Punkt (D) mit Punkt (A) jeweils verbinden, umgeben ist, wobei die Punkte (A), (B), (C) bzw. (D) Punkte (x = 1, y = 0, z = 0), (x = 0,4 , y = 0,6 , z = 0), (x = 0,4 , y = 0,3 , z = 0,3) bzw. (x = 0,1 , y = 0, z = 0,9) in dem ternären Nd-Ce-L-Diagramm sind.

4. Oxid-Supraleiter vom Nd-Ce-Ae-Cu-O-System, dadurch gekennzeichnet, daß er umfaßt:
eine Zusammensetzung, dargestellt durch die Summenformel: $(Nd_xCe_yAe_z)_2CuO_{4-d}$ (worin Ae eine Kombination von mindestens zwei Elementen, die zur Gruppe IIa des Periodensystems gehören, ist und x + y + z = 1) und in einer reduzierenden Atmosphäre nach dem Sintern wärmebehandelt, wobei die Nd-Ce-Ae-Zusammensetzung der Zusammensetzung einem Punkt entspricht, der in eine Fläche des ternären Nd-Ce-Ae-Diagramms fällt, die von geraden Linien (A-B), (B-C), (C-D) und (D-A), die Punkt (A) mit Punkt (B), Punkt (B) mit Punkt (C), Punkt (C) mit Punkt (D) und Punkt (D) mit Punkt (A) jeweils verbinden, umgeben ist, wobei die Punkte (A), (B), (C) bzw. (D) Punkte (x = 1, y = 0, z = 0), (x = 0,4 , y = 0,6 , z = 0), (x = 0,4 , y = 0,3 , z = 0,3) bzw. (x = 0,1 , y = 0, z = 0,9) in dem ternären Nd-Ce-Ae-Diagramm sind.

5. Verfahren zur Herstellung eines Oxid-Supraleiters, dadurch gekennzeichnet, daß es den folgenden Schritt umfaßt:
Wärmebehandlung eines Oxid-Sinterstoffs mit der Summenformel $(Nd_xCe_yM_z)_2CuO_{4-d}$ (worin M ein Element, ausgewählt aus Sr, Ca und Mg, ist und x + y + z = 1), wobei die Nd-Ce-M-Zusammensetzung der Zusammensetzung einem Punkt entspricht, der in eine Fläche des ternären Nd-Ce-M-Diagramms fällt, die von geraden Linien (A-B), (B-C), (C-D) und (D-A), die Punkt (A) mit Punkt (B), Punkt (B) mit Punkt (C), Punkt (C) mit Punkt (D) und Punkt (D) mit Punkt (A) jeweils verbinden, umgeben ist, wobei die Punkte (A), (B), (C) bzw. (D) Punkte (x = 1, y = 0, z = 0), (x = 0,4 , y = 0,6 , z = 0), (x = 0,4 , y = 0,3 , z = 0,3) bzw. (x = 0,1 , y = 0, z = 0,9) in dem ternären Nd-Ce-M-Diagramm sind, in einer reduzierenden Stickstoff-Atmosphäre.

6. Verfahren zur Herstellung eines Oxid-Supraleiters nach Anspruch 5, dadurch gekennzeichnet, daß der Schritt zur Wärmebehandlung bei einer Temperatur innerhalb eines Bereichs von 950 °C bis 1100 °C durchgeführt wird.

7. Verfahren zur Herstellung eines Oxid-Supraleiters, dadurch gekennzeichnet, daß es den folgenden Schritt umfaßt:
Wärmebehandlung eines Oxid-Sinterstoffs mit der Summenformel $(Nd_xCe_yAe_z)_2CuO_{4-d}$ (worin Ae eine Kombination von mindestens zwei Elementen, die zu der Gruppe IIa des Periodensystems gehören, ist und x + y + z = 1), wobei die Nd-Ce-Ae-Zusammensetzung der Zusammensetzung einem Punkt entspricht, der in eine Fläche des ternären Nd-Ce-Ae-Diagramms fällt, die von geraden Linien (A-B), (B-C), (C-D) und (D-A), die Punkt (A) mit Punkt (B), Punkt (B) mit Punkt (C), Punkt (C) mit Punkt (D) und Punkt (D) mit Punkt (A) jeweils verbinden, umgeben ist, wobei die Punkte (A), (B), (C) bzw. (D) Punkte (x = 1, y = 0, z = 0), (x = 0,4 , y = 0,6 , z = 0), (x = 0,4 , y = 0,3 , z = 0,3) bzw. (x = 0,1 , y = 0, z = 0,9) jeweils in dem ternären Nd-Ce-Ae-Diagramm sind, in einer reduzierenden Stickstoff-Atmosphäre.

8. Verfahren zur Herstellung eines Oxid-Supraleiters nach Anspruch 7, dadurch gekennzeichnet, daß der Schritt zur Wärmebehandlung bei einer Temperatur innerhalb eines Bereichs von 950 °C bis 1100 °C durchgeführt wird.

**Revendications**

1. Supraconducteur de type N à base d'oxyde du système Nd-Ce-L-Cu-O caractérisé en ce qu'il comprend :
une composition représentée par la formule de composition : $(Nd_xCe_yL_z)_2CuO_{4-d}$ (dans laquelle L est- un élément choisi parmi Ca et Mg, et x + y + z = 1), dont la composition en Nd-Ce-L correspond à un point se trouvant dans un domaine du diagramme ternaire Nd-Ce-L entouré de lignes droites (A-B), (B-C), (C-D) et (D-A) reliant le point (A) au point (B), le point (B) au point (C), le point (C) au point (D) et le point (D) au point (A) respectivement, les points (A), (B), (C) et (D) étant des points (x = 1, y = 0, z = 0), (x = 0,4, y = 0;6, z = 0), (x = 0,4, y = 0,3, z = 0,3) et (x = 0,1, y = 0, z = 0,9) respectivement du diagramme ternaire Nd-Ce-L.

2. Supraconducteur de type N à base d'oxyde du système Nd-Ce-Ae-Cu-O caractérisé en ce qu'il comprend :

une composition représentée par la formule de composition : $(Nd_xCe_yAe_z)_2CuO_{4-d}$ (dans laquelle Ae est une combinaison d'au moins deux éléments appartenant au groupe IIa de la classification périodique des éléments et x + y + z = 1), dont la composition en Nd-Ce-Ae correspond à un point se trouvant dans un domaine du diagramme ternaire de Nd-Ce-Ae entouré des lignes droites (A-B), (B-C), (C-D) et (D-A) reliant le point (A) au point (B), le point (B) au point (C), le point (C) au point (D) et le point (D) au point (A) respectivement, les points (A), (B), (C) et (D) étant des points (x = 1, y = 0, z = 0), (x = 0,4, y = 0,6, z = 0), (x = 0,4, y = 0,3, z = 0,3) et (x = 0,1, y = 0, z = 0,9) respectivement du diagramme ternaire de Nd-Ce-Ae.

3. Supraconducteur à base d'oxyde du système Nd-Ce-L-Cu-O caractérisé en ce qu'il comprend :

une composition représentée par la formule de composition : $(Nd_xCe_yL_z)_2CuO_{4-d}$ (dans laquelle L est un élément choisi parmi Ca et Mg, et x + y + z = 1) et traitée thermiquement dans une atmosphère réductrice après frittage dont la composition en Nd-Ce-L correspond à un point se trouvant dans un domaine du diagramme ternaire de Nd-Ce-L entouré de lignes droites (A-B), (B-C), (C-D) et (D-A) reliant le point (A) au point (B), le point (B) au point (C), le point (C) au point (D) et le point (D) au point (A) respectivement, les points (A), (B), (C) et (D) étant des points (x = 1, y = O, z = 0), (x = 0,4, y = 0,6, z = 0), (x = 0,4, y = 0,3, z = 0,3) et (x = 0,1, y = 0, z = 0,9) respectivement du diagramme ternaire de Nd-Ce-L.

4. Supraconducteur à base d'oxyde du système Nd-Ce-Ae-Cu-O caractérisé en ce qu'il comprend :

une composition représentée par la formule de composition : $(Nd_xCe_yAe_z)_2CuO_{4-d}$ (dans laquelle Ae est une combinaison d'au moins deux éléments appartenant au groupe IIa de la classification périodique des éléments et x + y + z = 1) et traitée thermiquement dans une atmosphère réductrice après frittage dont la composition en Nd-Ce-Ae correspond à un point se trouvant dans un domaine du diagramme ternaire de Nd-Ce-Ae entouré des lignes droites (A-B), (B-C), (C-D) et (D-A) reliant le point (A) au point (B), le point (B) au point (C), le point (C) au point (D) et le point (D) au point (A) respectivement, les points (A), (B), (C) et (D) étant des points (x = 1, y = 0, z = 0), (x = 0,4, y = 0,6, z = 0,), (x = 0,4, y = 0,3, z = 0,3) et (x = 0,1, y = 0, z = 0,9) respectivement du diagramme ternaire de Nd-Ce-Ae.

5. Procédé de préparation d'un supraconducteur à base d'oxyde caractérisé en ce qu'il consiste :

à traiter thermiquement en atmosphère réductrice d'azote un produit fritté à base d'oxyde ayant la formule de composition : $(Nd_xCe_yM_z)_2CuO_{4-d}$ (dans laquelle M est un élément choisi parmi Sr, Ca et Mg, et x + y + z = 1), dont la composition en Nd-Ce-M correspond à un point se trouvant dans le domaine du diagramme ternaire de Nd-Ce-M entouré de lignes droites (A-B), (B-C), (C-D) et (D-A) reliant le point (A) au point (B), le point (B) au point (C), le point (C) au point (D) et le point (D) au point (A) respectivement, les points (A), (B), (C) et (D) étant des points (x = 1, y = 0, z = 0), (x = 0,4, y = 0,6, z = 0), (x = 0,4, y = 0,3, z = 0,3) et (x = 0,1, y = 0, z = 0,9) respectivement du diagramme ternaire Nd-Ce-M.

6. Procédé de préparation d'un supraconducteur à base d'oxyde tel que revendiqué à la revendication 5, caractérisé en ce qu'il consiste à effectuer le stade de traitement thermique à une température comprise entre 950 et 1.100°C.

7. Procédé de préparation d'un supraconducteur à base d'oxyde,

caractérisé en ce qu'il consiste :

à traiter en atmosphère réductrice d'azote un produit fritté à base d'oxyde ayant la formule de composition : $(Nd_xCe_yAe_z)_2CuO_{4-d}$ (dans laquelle Ae est une combinaison d'au moins deux éléments appartenant au groupe IIa de la classification périodique des éléments et x + y + z = 1), dont la composition en Nd-Ce-Ae correspond à un point se trouvant dans un domaine du diagramme ternaire de Nd-Ce-Ae entouré des lignes droites (A-B), (B-C), (C-D) et (D-A) reliant le point (A) au point (B), le point (B) au point (C), le point (C) au point (D) et le point (D) au point (A)respectivement, les points (A), (B), (C) et (D) étant des points (x = 1, y = 0, z = 0), (x = 0,4, y = 0,6, z = 0), (x = 0,4, y = 0,3, z = 0,3) et (x = 0,1, y = 0, z = 0,9) respectivement du diagramme ternaire de Nd-Ce-Ae.

8. Procédé de préparation d'un supraconducteur à base d'oxyde suivant la revendication 7, caractérisé en ce qu'il consiste à effectuer le stade de traitement thermique à une température comprise entre 950 ° C et 1.100 ° C.

FIG.1

FIG.2

FIG.3